# EUROPEAN PATENT SPECIFICATION

(11) **EP 4 232 503 B1**
(45) Date of publication and mention of the grant of the patent: **05.03.2025**
(21) Application number: 22809807.5
(22) Date of filing: 28.10.2022
(51) Int. Cl.: C08G 77/442, G02B 1/00, H05K 3/28, C08L 83/04, C09D 183/04

(54) **RESIST MIXTURE**
LACKMISCHUNG
MELANGES RÉSIST

(30) Priority: 29.10.2021 GB 202115612
(43) Date of publication of application: 30.08.2023
(73) Proprietor: Faradaic Sensors GmbH, 10585 Berlin (DE)
(72) Inventor: GUTERMAN, Ryan, 10585 Berlin (DE)
(74) Representative: EIP
(86) International application number: PCT/EP2022/080231
(87) International publication number: WO 2023/073186

(56) References cited:
- JP-A- 2015 064 516
- KR-B1- 102 293 308
- US-A1- 2021 080 829

## Description

### Background

Devices such as batteries, sensors, photovoltaics, and others rely on the flow of ions during their operation. This may be achieved by using a liquid electrolyte, e.g. a liquid comprising dissolved ions that allows the flow of ions. However, such electrolytes can suffer leakage and/or evaporation, which in turn affects the conductivity required for a given purpose. It is desirable to mitigate such problems. US2021/080829A1 relates to a negative photosensitive resin composition and cured film.

### Brief Description of the Drawings

Figure 1 schematically shows a structure of a polymer in accordance with examples.
Figure 2 schematically shows a structure of a polymer in accordance with further examples.
Figure 3 schematically shows a structure of a polymer in accordance with further examples.
Figure 4 schematically shows a structure of a polymer in accordance with further examples.
Figure 5 schematically shows a structure of a polymer in accordance with further examples.
Figure 6 schematically shows a synthesis and a structure of a polymer in accordance with examples.
Figure 7 schematically shows a synthesis and a structure of a polymer in accordance with further examples.
Figure 8 schematically shows a synthesis and a structure of a polymer in accordance with further examples.
Figure 9 schematically shows a crosslinkable resist mixture in accordance with examples.
Figure 10 schematically illustrates a process of manufacturing a ion-conductor in accordance with examples.
Figure 11 schematically illustrates a process of manufacturing a ion-conductor in accordance with further examples.
Figure 12 schematically illustrates a process of manufacturing an ion-conductor in accordance with further examples.
Figure 13 schematically illustrates a process of manufacturing an ion-conductor in accordance with further examples.
Figure 14 schematically illustrates a microchip assembly comprising an ion-conductor in accordance with examples.

### Detailed Description

Examples described herein relate to a resist mixture which can be used to form a material through which ions can flow for conducting electricity.

In some examples a resist mixture comprises a crosslinker for reducing mobility of a polymer to which at least one of a cationic component or an anionic component is bonded; such examples are referred to below as a first class of examples.

In examples of the first class, the resist mixture is crosslinkable and comprises: a polymer comprising siloxane; a crosslinker; and a salt comprising a cationic component, and an anionic component. At least one of the cationic component or the anionic component of the salt is bonded to the polymer, for example, directly by a covalent bond or by a linker which is covalently bonded to at least one of the cationic component or the anionic component of the salt and to the polymer. The bond between the polymer and the component of the salt e.g. reduces leakage or leaching of the salt and/or the potential washing away of the salt during any development or solvent washing step after cross linking. Further, by maintaining ionic sites within the crosslinked material to which ions (the other of the cationic or anionic component not bonded to the polymer, and which component flows to provide an electrical/ionic current) can be attracted, the crosslinked material can maintain its ion-conductive properties for a longer period of time compared with a leachable electrolyte, which can increase the usable lifetime of a device (e.g. an electromechanical device incorporating the crosslinked and/or immobilised material). Further, it has been realised that in examples, the glass transition temperature of the polymer is 260 Kelvin or less, which at room temperature (298K), gives freely mobile ions within the substance. In some examples, such as at a glass transition temperature of 230 Kelvin or less, or 200 Kelvin or less, there is improved free ion mobility compared with higher glass transition temperatures. In examples, the amphiphilic nature of the polymer results in the formation of phase-separated domains in which the ions can flow. In some examples, crosslinking the resist mixture reduces mobility of the polymer chains, e.g. substantially immobilises the polymer chains such that the material can be considered quasi- or solid-state. Such properties give useful ion-conductivity and physical properties for various purposes.

In examples of the first class, the resist mixture is patternable by, for example, crosslinking one or more regions of the resist mixture after the mixture is deposited on a substrate. Then, other regions of the mixture which were not crosslinked can be removed to leave behind the crosslinked regions patterned as desired for a given purpose, e.g. for a given electromechanical device requiring a patterned structure with electrical conductivity. Hence the resist mixture can be considered to be a mixture which functions as a resist, in that the resist mixture can be treated under certain chemical and/or physical conditions to harden, solidify or otherwise change chemical and/or physical properties so as to be useful for patterning when deposited on a substrate. Where for example the treated resist remains on the substrate while removing untreated regions of the resist, the resist can be referred to as a negative resist.

Such chemical and/or physical treatment of the resist mixture is e.g. exposing the resist mixture to electromagnetic radiation such as light (e.g. ultraviolet light) in the case of a photoresist, or to radiation such as an electron beam, or to heat. Such exposure causes crosslinking of the mixture such that the crosslinked material is sufficiently insoluble to a solvent or other developer material used to remove regions of the deposited mixture which were not selected to be crosslinked.

A second class of examples is also referred to herein, which are similar in functionality to examples of the first class in respect of reducing mobility of the polymer to which at least one of the cationic component or the anionic component is bonded, except that instead of, or in addition to, a crosslinker in the resist mixture being used to reduce mobility of the polymer to which at least one of the cationic component or the anionic component is bonded, a monomer in the resist mixture is polymerised in order to reduce mobility or immobilise the polymer to which at least one of the cationic component or the anionic component is bonded. The polymerised monomer is a polymer different from the first polymer and comprises a siloxane or a non-siloxane and may also comprise a cationic or anionic component bonded to it. In some examples, the polymerisable monomer in the second class of examples can also itself, additionally be crosslinkable to further reduce the mobility of the polymer to which at least one of the cationic component or the anionic component is bonded. Further details of examples particular to the first class, and separately to the second class are described below. But it is to be appreciated that certain functionalities apply both to the first and second classes of examples.

In examples of the second class, the resist mixture is polymerisable and comprises at least: a polymer comprising siloxane; a monomer; and a salt comprising a cationic component, and an anionic component. Similar as for examples of the first class, at least one of the cationic component or the anionic component of the salt is bonded to the polymer. The polymerisable resist mixture is patternable similarly as described for the examples of the first class, except that instead of, or in addition to, crosslinking, the resist mixture polymerises by polymerising the monomer, e.g. by chemical and/or physical treatment such as exposing the resist mixture to electromagnetic radiation such as light. In some examples, the polymerisable resist mixture comprises a crosslinker, which in some examples is separate from the monomer in the mixture, and in other examples is part of the monomer (e.g. a crosslinker is covalently bonded to the monomer and/or the monomer comprises the crosslinker). The polymerisation of the monomer and the crosslinking of the crosslinker (e.g. between chains of the polymerised monomer, or between chains of the polymer with at least one of the cationic component or the anionic component bonded to the polymer, or between chains of each of the polymerised monomer and chains of the polymer with at least one of the cationic component or the anionic component bonded to the polymer) can be considered to form a molecular network which reduces mobility, e.g. by entanglement, of the polymer which has the at least one of the cationic component or the anionic component bonded thereto. Crosslinking can occur either during the polymerisation reaction of the monomer, or instead after the polymerisation of the monomer has occurred. In other examples without a crosslinker (either separate from the monomer in the mixture or part of the monomer), the polymerised monomer itself can reduce mobility of the polymer with the at least one of the cationic component or the anionic component bonded thereto.

In some examples of the first and second classes, the polymer comprising siloxane is referred to as a first polymer, and the mixture further comprises a second polymer different from the first polymer. Note that the term second polymer is used to refer to a different polymer than the polymerised monomer described herein for the second class examples. The second polymer is a non-siloxane polymer or a siloxane polymer different from the first polymer. This second polymer in some examples has a crosslinker (e.g. similar to those described in other examples) covalently bonded to it, which can be used to crosslink second polymer chains together in the mixture.

As will be appreciated, a crosslinker can be considered a molecule or chemical group which is reactive (e.g. by appropriate initiation) to bond two or more polymer chains together, to form a crosslinked material from the resist mixture, and thus can be distinguished from a monomer which undergoes a polymerisation reaction to form a polymer chain. By use of a crosslinker, in some examples a chain of the first polymer is bonded to another chain of the first polymer, in other examples a chain of the second polymer is bonded to another chain of the second polymer, in further examples a chain of the first polymer is bonded to a chain of the second polymer, and in yet further examples a chain of the first polymer or the second polymer is bonded to a chain of the polymerised monomer. The method of crosslinking is usually determined by the crosslinking chemistry chosen. The density and resulting physical properties (e.g. glass transition, solvent resistance and/or hardness) of the material depends for example on the molecular nature of the crosslinker and how many reactive sites are available for bonding. The extent of crosslinking depends not just on the particular molecular structure of the crosslinker, but in some examples also on the extent of initiation (e.g. the duration or intensity of exposure of the mixture to light or heat).

The crosslinked and/or polymerised material of examples can be considered an ion-conductive material, in that the anionic or cationic component of the salt, which respectively can be considered anions or cations, not bonded to the polymer can flow. This can be considered an ionic conductivity, in that ions are conductible through the material, e.g. to provide an electrical and/or ionic current. In examples the crosslinked or polymerised material has sufficient ion-conductivity without also needing a solvent, plasticiser or any electrolyte unbonded to the polymer.

In some examples, the salt comprises at least one of a carbon-carbon bond or a carbon-hydrogen bond, and so in examples may be considered an organic salt. The salt is, in some examples, an ionic liquid. An ionic liquid referred to herein is for example, when isolated, a liquid or glass at 373 Kelvin. In some examples the salt comprises at least one of a zwitterion, a multi-cation or a multi-anion.

The crosslinked or polymerised material can in some examples be considered a solid-state ion-conductor, in that the material is substantially solid yet still ion-conductive. Substantially solid-state includes examples not just of fully solid-state crosslinked or polymerised material but also material which is not entirely solid, but which is predominantly solid or more solid than liquid (homogeneously throughout the material) as well as materials which are a so-called quasi-solid-state ion-conductor, for example a gel, a semi-solid or a glass. In some examples such materials contain no or substantially no (within functional tolerances) leachable free liquid or solvent which contribute to ion and/or electrical conductive properties of the material. This is desirable as it allows the ion-conductor to be more resistant to degradation and reduces the leaching of substances from the ion-conductor.

More detailed examples will now be described with appropriate reference to the Figures.

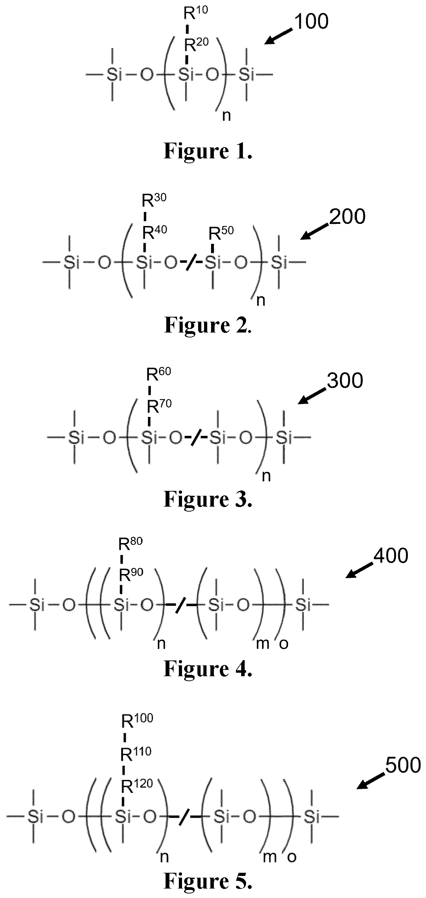

Figure 1 illustrates an example polymer 100 wherein R¹⁰ is the cationic component or anionic component of the salt bonded to a siloxane polymer backbone of the polymer. Examples of the cationic component of a salt that could be bonded to the polymer include: triazolium, thioimidazolium, a quaternary ammonium, a protonated tertiary amine, imidazolium, substituted imidazolium, a quaternary phosphonium, a protonated tertiary phosphine, chloronium, pyrrolidinium, a substituted pyrrolidinium, pyridinium, a substituted pyridinium, a sulfonium or a substituted sulfonium. Examples of the anionic component of a salt that could be bonded to the polymer include: a sulfonate, a phosphonate, alkoxide, a triflate, a thiolate, an imidazolate, tosylate, (methyl)acrylate, carboxylate, acetate, dimethylphosphate, or methylsulfate. Other cationic and anionic components are envisaged that are not suitable for being covalently bonded to the polymer, for example: tetrakis(pentafluorophenyl)borate, bis(fluorosulfonyl)imide, hexafluorophosphate, bis(trifluoromethane)sulfonimide (bistriflimide/TFSI)), tetrafluoroborate, chloride, bromide, or iodide. R²⁰ is a linker or a covalent bond; in further examples it is envisaged that molecular variants of such cationic and anionic components are covalently bonded to the polymer. Example linkers include ethane-1,2-diyl, 1-oxopropane-1,3-diyl, 1-oxoethane-1,2-diyl and 1,5-dioxo-3-hydroxy-pentane-1,5-diyl, illustrated below: 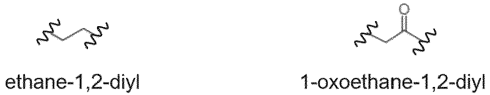 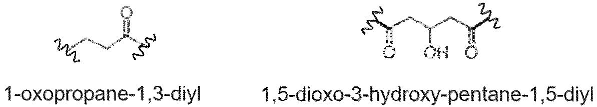 though different linkers are envisaged in further examples. The choice of the properties of the linker, such as length, allow the tuning of the conductivity and morphology of any ion channels when the mixture is crosslinked. The polymer 100 when combined with a crosslinker gives a crosslinkable resist mixture of examples described herein, e.g. for manufacturing an ion-conductor. In some examples the salt comprises a zwitterion, a multi-cation, or multi-anion (eg. cationic functionalised imidazolium such as butyl-methyl-imidazol-2-ylidene borane, others are envisaged) which allow different ion channel structures and allow modification of the ionic conductivity. A person skilled in the art will appreciate that the terms n, m, and o in figures 1 to 9 indicate the number of repeating units of each polymeric block. Each term could be, for example, any integer between 1 and 100,000 (including 1). In some examples a plurality of the terms are equal.

An example polymer 200 of a crosslinkable resist mixture e.g. for manufacturing an ion-conductor is schematically illustrated by Figure 2. Polymer 200 is a random copolymer which comprises a siloxane polymer backbone. R³⁰ is the cationic component or anionic component of a salt. The same examples are envisaged for R³⁰ as are previously outlined for R¹⁰. R⁴⁰ is a linker or a covalent bond, with the same examples envisaged for R⁴⁰ as previously outlined for R²⁰. R⁵⁰ is a crosslinker. Example crosslinkers covalently bonded to the siloxane polymer include prop-2-en-1-yl, butan-3-en-1-yl, and 5-(prop-2-enoyloxy)-pentan-1-yl, illustrated below: 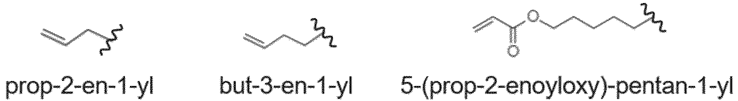 different linkers are envisaged. In some examples the crosslinker is crosslinkable by a catalytic reaction, for example, crosslinkers which are crosslinkable by a photoinitiated allkyne-azide click reaction.

A slash symbol "/" through a bond is used in figures 2 to 9 to indicate separate subunits of the copolymer and the random nature of the copolymer, that is, that the sequence and connectivity as well as the stoichiometry of the two or more subunits is variable. Alternatively, the copolymers are, for example, a dendrimer, and/or a copolymer of other configurations such as block, diblock, triblock, alternate, and/or graft copolymers. The bonding of the crosslinker and at least one of the cationic component or anionic component to the polymer facilitates the use of a single component mixture, in other words a mixture with a polymer without needing a separate crosslinker, which in some examples simplifies processing, and use.

Figure 3 schematically illustrates an example of a polymer 300 to provide a crosslinkable resist mixture e.g. for manufacturing an ion-conductor when mixed with a crosslinker. Polymer 300 is a random copolymer and comprises a siloxane polymer backbone. R⁶⁰ is the cationic component or anionic component of an ionic liquid. The same examples are envisaged for R⁶⁰ as are previously outlined for R¹⁰. R⁷⁰ is a linker or a covalent bond; the same examples are envisaged for R⁷⁰ as are previously outlined for R²⁰. In some examples, the chosen stoichiometry of the two subunits allows the tuning of the conductivity and morphology of any ion channels when the mixture is crosslinked.

An example polymer 400 for a crosslinkable resist mixture e.g. for manufacturing an ion-conductor when mixed with a crosslinker is schematically illustrated in Figure 4. Polymer 400 is a block copolymer that comprises a siloxane polymer backbone. R⁸⁰ is the cationic component or anionic component of a slat, with the same examples envisaged for R⁸⁰ as are previously outlined for R¹⁰. R⁹⁰ is a linker or a covalent bond, with the same examples envisaged for R⁹⁰ as are previously outlined for R²⁰. In some examples, the choice of values of n, m and o allows the tuning of the conductivity and morphology of any ion channels when the mixture is crosslinked. In some examples, m is zero.

Figure 5 schematically illustrates an example of a polymer 500 to provide a crosslinkable resist mixture e.g. for manufacturing an ion-conductor. Polymer 500 comprises a siloxane polymer backbone. R¹¹⁰ is the cationic component or anionic component of an ionic liquid. The same examples are envisaged for R¹¹⁰ as are previously outlined for R¹⁰. R¹²⁰ is a linker or a covalent bond; the same examples are envisaged for R¹²⁰ as are previously outlined for R²⁰. R¹⁰⁰ is a crosslinker; the same examples are envisaged for R¹⁰⁰ as are previously outlined for R⁵⁰

In some examples the mixture comprises a monomer, for example, 1,6-hexanedioldiacrylate, though different monomers are envisaged in further examples. As will be appreciated, a monomer can be considered a molecule which undergoes a polymerisation reaction to form a polymer chain. In examples the monomer is polymerised to form a polymer, for example poly(1,6-hexanedioldiacrylate), though other polymers are envisaged in other examples. In some examples the polymer bonded to at least one of the cationic component or the anionic component has reduced mobility (e.g. is immobilised and/or cannot be removed from the mixture by being dissolved in a solvent), because it is entangled or otherwise immobilised with the polymerised monomer.

In some examples, the mixture comprises a second polymer, for example a polystyrene, a polyacrylate or a polysiloxane. In some examples the second polymer comprises a crosslinker, for example: a polyester functionalised with an acrylate, a urethane functionalised with an acrylate, or an olefin; other polymers comprising a crosslinker envisaged. A person skilled in the art will appreciate that in some examples the crosslinker requires a catalyst, a photoinitiator and/or sensitizer to be crosslinked. In some examples the mass ratio of the first polymer to the second polymer is between 1:100 and 100:1, in further examples the mass ratio of the first polymer to the second polymer is between 1:5 and 5:1. The second polymer in some examples comprises siloxane, and in other examples the second polymer is a non-siloxane polymer (in other words a polymer without siloxane). In some examples, when the second polymer is crosslinked, the first polymer is reduced in mobility, e.g. immobilised and/or the first polymer cannot be removed from the crosslinked second polymer by being dissolved in a solvent. In other examples, when the second polymer is crosslinked, the first polymer is not immobilised and/or the first polymer can be removed from the crosslinked second polymer by being dissolved in a solvent.

In some examples the mixture comprises a polymerisable and crosslinkable monomer, for example, SU-8, illustrated below: 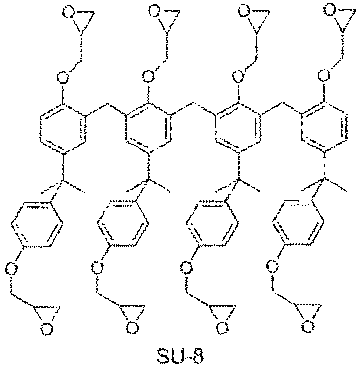 different monomers are envisaged in further examples.

In some examples, the mixture comprises several different monomers which are polymerisable and crosslinkable. For example, the mixture comprises a first formulation comprising 50 wt% (a person skilled in the art will appreciate the use of weight percent) trimethyloylpropane triacrylate, 20 wt% 1,6-hexanediol diacrylate, 25 wt% acrylic acid, and a 5 wt% photoinitiator; trimethyloylpropane triacrylate 1,6-hexanediol diacrylate and acrylic acid are illustrated below. 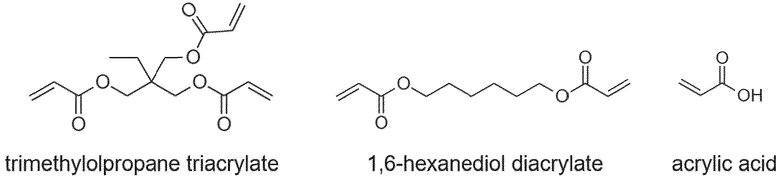 The first formulation is mixed with a second formulation comprising the first polymer and the salt to form the mixture. A further example of a first formulation is a 50 wt% polyurethane acrylate and 45 wt% trimethylolpropane triacrylate and 5 wt% photoinitiator. In some examples the mass ratio of the first formulation to the second formulation is between 1:100 and 100:1, in further examples the mass ratio of the first formulation to the second formulation is between 1:5 and 5:1.

Some examples of a mixture of the present disclosure contain a plurality of different polymers, for example, each having the general formula of one of figures 1 to 5, for example each in accordance with the general formula of Figure 1. In other examples the different polymers are each of a different general formula. The degree to which each component of a mixture comprising a single polymer species having the general formula can be achieved is limited by the purity of available starting materials, the synthetic routes used to make the compositions, and the degree of purification that can be achieved.

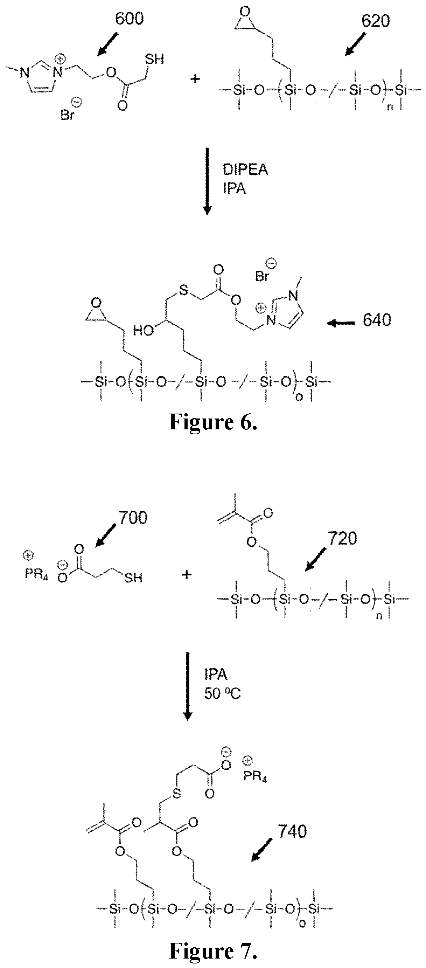

In examples, such as those of Figure 6, the crosslinkable resist mixture comprises random copolymer 640. Random copolymer 640 is synthesised by combining ionic liquid 600 (1-methyl-3-ethyl sulfanyl-acetyl-imidizolium bromide) and the siloxane random copolymer 620 (poly-1,2-epoxypentyl-siloxane - random - siloxane) at a 1:2 thiol:epoxy ratio. The mixture is solubilised with isopropanol and the reaction catalysed with 1 mol% (a person skilled in the art will appreciate the use of mole percent) diisopropylethylamine. After stirring the mixture for 16 hours at room temperature (298 Kelvin), random copolymer 640 is isolated by precipitation in diethylether and evaporation of volatiles. A crosslinked material, e.g. an ion-conductor, is produced by depositing and crosslinking a mixture produced by mixing polymer 640 with a 5 wt% (4-methylthiophenyl)methyl phenyl sulfonium trifluoromethanesulfonate. The mixture is, for example, deposited on a substrate by spin-coating the mixture on to a substrate at 3000 revolutions per minute (RPM, equivalent to 60x s⁻¹ in S.I. units) for one minute. A region of the mixture on the substrate is crosslinked by selectively exposing the region of the mixture on the substrate to ultraviolet (UV) radiation (for example, from a mercury bulb through a photomask; however, other UV sources such as a light emitting diodes or lasers are envisaged) for 30 seconds. The substrate is then heated by being placed in contact with a hot plate at 338K for two minutes followed by 368K for two minutes. The region of the mixture that has not been crosslinked by the UV radiation is dissolved and removed using acetone, which produces a patterned crosslinked material e.g. an ion-conductor on the substrate.

Figure 7 schematically illustrates a synthesis of the random copolymer 740 for a crosslinkable resist mixture e.g. for manufacturing an ion-conductor. Random copolymer 740 is synthesised by combining random copolymer 720 (poly-propyl-acetyl-siloxane - random - siloxane) and ionic liquid 700 (phosphonium 3-sulfanylpropanoic acid) at a 1:2 thiol:acrylate ratio. The mixture is solubilised with isopropanol and heated to 323 Kelvin. After stirring for 16 hours at room temperature (298 Kelvin), the mixture is precipitated in diethylether and the volatiles are evaporated to isolate reactive polymer 740.

A crosslinked material, e.g. an ion-conductor is produced by depositing and crosslinking a mixture produced by mixing polymer 740 with 10 wt% pentaerythritol tetraacrylate and 5 wt% 2,2-dimethoxy-1,2-diphenylethanone. The mixture is e.g. deposited on the substrate by spin coating the mixture on to a substrate at 3000 RPM for one minute. A region of the mixture on the substrate is crosslinked by exposing the region to UV light through a photomask for 30 seconds. The region of the mixture that has not been crosslinked by the UV radiation is dissolved and removed using isopropanol.

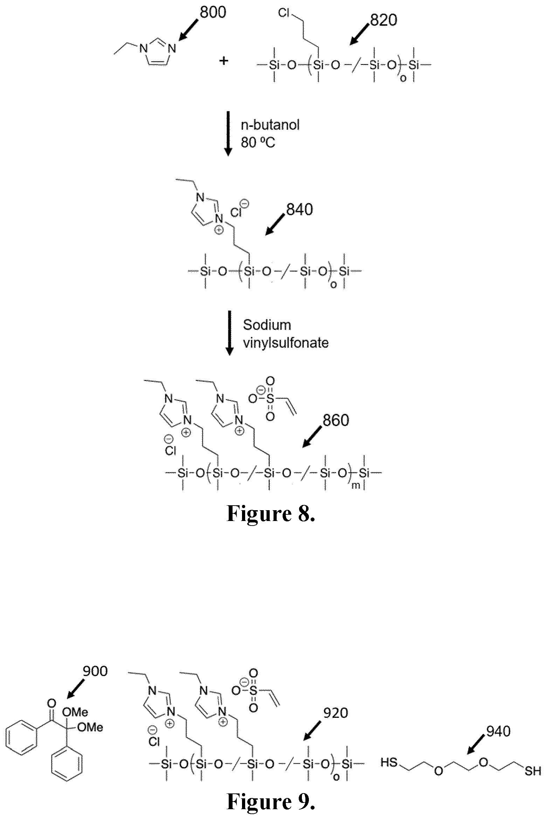

In examples, such as those of Figure 8, the crosslinkable resist mixture e.g. for manufacturing an ion-conductor comprises polymer 860. Polymer 860 is a random copolymer and is synthesised by combining substituted imidazole 800 (1-ethyl-imidizole) and polymer 820 (1-chloro-propyl-siloxane-random-siloxane) at a 2:1 imidazole:alkylchloride ratio. The mixture is solubilised with n-butanol and slowly heated to 353 Kelvin. After stirring for 16 h at room temperature (298 Kelvin), the mixture is precipitated in diethylether and the volatiles are evaporated to isolate polymer 840. Polymer 860 is derived from polymer 840 by mixing polymer 840 with a sub-stoichiometric amount of sodium vinylsulfonate.

A crosslinked material such as a solid-state ion-conductor is produced by depositing and crosslinking a mixture of polymer 860 and 1,2-bis(2-mercaptoethoxy)ethane at a 1:1 ratio of thiol to -ene and 2 wt% 2,2-dimethoxy-1,2-diphenylethanone. The mixture is deposited on a substrate by spin-coating the mixture on to the substrate at 3000 RPM for one minute. A region of the mixture on the substrate is crosslinked by is exposing the region to UV radiation through a photomask for 30 seconds. The region of the mixture that has not been crosslinked by the UV radiation is dissolved and removed using acetone. In other examples, the addition of 1,2-bis(2-mercaptoethoxy)ethane is forgone as polymer 860 already comprises a crosslinker.

Figure 9 illustrates example components for the crosslinkable resist mixture e.g. for manufacturing an ion-conductor, specifically a photo-initiator 900 (2,2-dimethoxy-1,2-diphenylethanone), an example siloxane polymer 920 with a substituted imidazolium covalently bonded to a siloxane backbone, and crosslinker 940 (2,2'-(ethylenedioxy)diethanethiol). A photoinitiator is used to facilitate the crosslinking of a mixture. A person skilled in the art will appreciate that under the influence of light the 2,2-dimethoxy-1,2-diphenylethanone will form radicals which initiate the radical polymerisation; however, other photoinitiators and mechanisms of photoinitiated polymerisation are envisaged. For some examples a photoinitiator is not needed due to the choice of radiation and/or the choice of crosslinking chemistry.

In examples, the crosslinkable or polymerisable mixture is e.g. for manufacturing an ion-conductor and comprises an additive or additives to modify the properties of the mixture or the mixtures when it has been crosslinked. In some examples additives such as butyl acrylate are added to the mixture to modulate the density of crosslinks when the mixture is crosslinked and/or plasticisers such as triethyleneglycol methylether methacrylate are added to plasticise the mixture and/or the mixture when it is crosslinked. In some examples the plasticiser is a reactive plasticiser, for example butyl acrylate, triethyleneglycol acrylate or siloxane acrylate. In other examples the plasticiser is a non-reactive plasticiser, for example propylene glycol or 1-ethyl-3-butyl-imidazolium tetrafluoroborate. Other plasticisers are envisaged. Changing the density of crosslinks or plasticising the mixture allows modification of the physical properties of the crosslinked mixture. Some examples of the mixture comprise a catalyst, a photoinitiator and/or sensitiser to allow and/or assist the crosslinking and/or polymerisation of the mixture.

Some examples allow the modification of the electronic and/or ionic properties of the mixture or of the crosslinked mixture by the addition of a redox active additive, e.g. vinyl ferrocene. This allows the tuning of the electronic and/or ionic properties, for example for applications as an electrolyte.

In examples, the resist mixture comprising one or more additive to modify one or more properties of the mixture or resulting crosslinked / polymerised mixture. Such properties include for example electronic, catalytic, mechanical, optical, mass transport or processing properties. Such an additive is for example metallic, semiconducting, insulating, or non-metallic, and/or comprises nanoparticles, microparticles, clusters, fillers, nanotubes, a clay, graphene, quantum dots, and/or carbon such as carbon black or graphite. Such an additive, e.g. fillers, is present in the range of for example 0.0001 wt% to 98 wt%, such as 0.01 wt% to 30 wt%.

In some examples the crosslinkable resist mixture for manufacturing an ion-conductor comprises a chromophore. For some examples a chromophore will modulate electromagnetic radiation applied to the mixture, which in some examples allows more efficient crosslinking. In examples, a chromophore is used to provide fluorescent properties to the at least partially crosslinked ion-conductor. The chromophore is, for example, a rhodamine or a rhodamine derivative; however other chromophores are envisaged depending on the desired electromagnetic properties.

Many different examples of polymer mixtures are envisaged that possess ionic functionality and/or crosslinking functionality, as siloxane polymers with a variety of functional groups for crosslinking or suitable for attachment of a component of a salt are commercially available. Many different examples of salts and crosslinkers are envisaged as many suitable salts and crosslinkers are commercially available. In some examples, the crosslinker in the mixture is not bonded to the polymer. In some examples, the crosslinker in the mixture is bonded to the polymer, allowing the polymer to crosslink with itself. A person skilled in the art will also appreciate that any of the polymers referred to herein can be, for example, a simple polymer, a dendrimer, and/or a copolymer of various configurations such as block, diblock, triblock, random, alternate, and/or graft copolymers.

In some examples the mixture comprises a plurality of different crosslinkers, in some examples the different crosslinkers are crosslinkable by different reaction pathways. In some examples both the first polymer and the second polymer are crosslinkable. For example, the mixture comprises polymer 640, a polyurethane acrylate and a combination of photoinitiator, other such mixtures are envisaged. In some examples of such mixtures a plurality of crosslinking mechanisms occur.

In some examples the mixture comprises a polymer wherein a first crosslinker is covalently bonded to the polymer; and a second crosslinker. For example, the mixture comprises polymer 860 and SU-8, other examples are envisaged. In such examples, upon irradiation of this mixture a plurality of crosslinking mechanisms are envisaged. In some examples the mass ratio of the polymer to the monomer is between 1:100 and 100:1, in further examples the mass ratio of the polymer to the monomer is between 1:5 and 5: 1.

In some examples, the crosslinkable resist mixture is e.g. for manufacturing an ion-conductor and comprises a surfactant. The surfactant is, for example, non-ionic (e.g. polysorbate), anionic (e.g. sodium lauryl sulfate), cationic (e.g. benzalkonium chloride), or amphoteric (e.g. cocoamidpropl betaine). The surfactant allows the modification of structure of ion channels that are produced within the crosslinked solid-state ion-conductor in some examples, which consequently allows tuning of the ion conductivity. Tuning ion conductivity is also, for example, achievable by varying the amount of incorporated salt, which, in some examples influences the shape and extent of the phase separated regions and formed ion channels, and in some examples affects the glass transition.

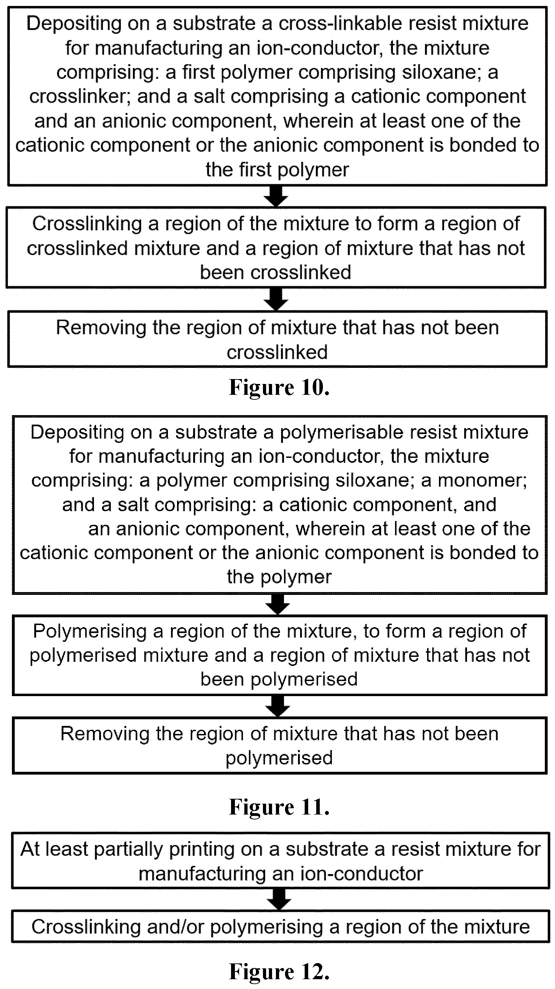

An example process of manufacturing a crosslinked material, e.g. an ion-conductor is described in Figure 10. The process comprises: at least partially depositing the crosslinkable resist mixture for manufacturing an ion-conductor on the substrate; crosslinking a region of the mixture; and at least partially removing a region of non-crosslinked mixture. This allows the selection of different regions of the resist to be crosslinked or not crosslinked, for patterning of an ion-conductor on a substrate. Note that a substrate described herein for any example described herein can e.g. be any structure, element or other item with a surface (which is for example planar) on which the resist mixture can be deposited, e.g. for crosslinking, polymerising and/or patterning in accordance with examples herein.

An example process of manufacturing a polymerised material, e.g. an ion-conductor is described in Figure 11. The process comprises: at least partially depositing the polymerisable resist mixture for manufacturing an ion-conductor on the substrate; polymerising a region of the mixture; and at least partially removing a region of the mixture that has not been polymerised. This allows the selection of different regions of the resist to be polymerised or not polymerised, for patterning of an ion-conductor on a substrate.

In examples, at least partially depositing a mixture on a substrate is achieved by casting the mixture, coating the mixture on the substrate, spin-casting or spin-coating; however other methods are envisaged. In some examples, before depositing the mixture by some techniques, such as solution deposition, the surface of the substrate is treated and/or cleaned. For example, the surface is cleaned by plasma cleaning. In some examples, the surface is chemically treated, for example to improve adhesion or introduce surface functionality. For some examples, cleaning of the surface improves the adhesion of the mixture to the substrate. In some examples the mixture comprises an adhesion additive which increases adhesion of the mixture to the surface, example adhesion additives are an acrylate when the surface is glass or a thiol when the surface is gold, other adhesion additives and surfaces are envisaged. In some examples the adhesion additive is bonded to the polymer, in other examples, the adhesion is not bonded to the polymer. The mixture is deposited in a thickness, for example, the mixture is deposited in a thickness from 50 nm to 5mm.

Some examples comprise exposing the region of the mixture to radiation to cause the crosslinking. Examples of radiation include an electron beam and electromagnetic radiation. In examples, the mixture is selectively radiated by the use of a mask, such as a photolithographic mask, projector, and/or by modulating the source of radiation, such as by rastering a laser across the region of the mixture whilst selectively controlling the power of the laser. In some examples the resist mixture is heated or annealed to cause the crosslinking. In some examples this is achieved with thermal initiators, in other examples this is achieved without thermal initiators. In some examples where thermal initiators are not used, crosslinking is achieved at temperatures of 423 Kelvin and above. In some examples where thermal initiators are used, crosslinking is achieved at room temperature (298 Kelvin), in further examples where thermal initiators are used, this is achieved at a temperature between 323 Kelvin and 393 Kelvin. Some examples undergo heating at any point in manufacture which allows the facilitation of chemical reactions and/or the removal of volatiles from the crosslinked material.

In some examples, such as those of Figure 12, depositing the resist mixture e.g. for manufacturing an ion-conductor on a substrate comprises printing the mixture on to the substrate, for example using an inkjet printer; however other printing methods are envisaged. When the mixture is printed onto the substrate it is not always necessary to remove the region of mixture that has not been crosslinked and/or polymerised by the crosslinking and/or polymerisation process as the printing allows the patterning of the mixture on the substrate. This allows the incorporation of components (such as potentially highly leachable components) which would otherwise degrade or be removed if they were exposed to a developer for removal of the region of the mixture that has not been crosslinked. In some examples, the printed ion-conductor is resistant to deformation, deswelling, or creep due to changes in temperature or the passage of time. Printing also allows for the production of an ion-conductor in a manner which is compatible with other common microfabrication techniques, which in turn, in some examples simplifies the inclusion of the ion-conductor in a microchip or microelectronics. In some examples the printed ion-conductor is resistant to solvents and chemical vapours. Resistance to solvents and chemical vapours, for example, allows the ion-conductor to be exposed to other common microfabrication techniques without reducing the ion-conductivity of the ion conductor.

Other techniques envisaged for providing the resist mixture on a substrate include for example drop casting, dip coating, spray coating, roll coating, painting, doctor blading, and imprint lithography.

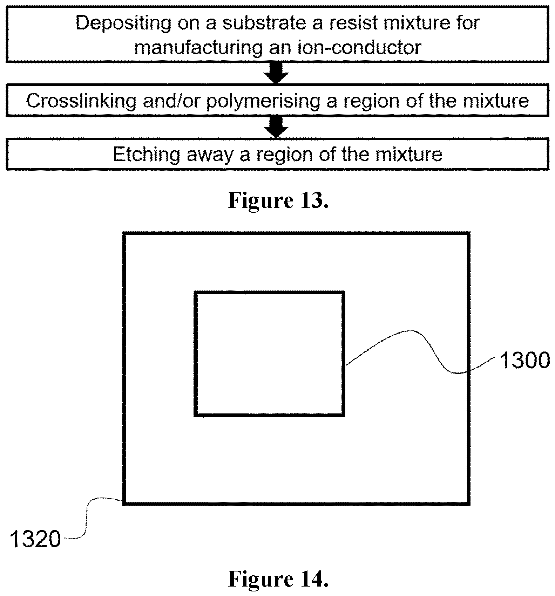

An example process of manufacturing an ion-conductor is described in Figure 13. The process comprises: depositing the resist mixture for manufacturing an ion-conductor on the substrate; crosslinking and/or polymerising the mixture; and at etching away a region of crosslinked and/or polymerised mixture. This allows the selection of regions of the resist to etch away. Etching, for example, is achieved chemically and/or radiatively. Etching for example gives the patterning of the solid-state ion-conductor on a substrate.

It is to be appreciated that in some examples an additive of the resist mixture, such as a filler or dissolved substance, can be etched, extracted or removed from the crosslinked / polymerised mixture to increase porosity of the resulting material. The filler or dissolved substance can be developed then etched, or developed where the developer is the etchant. For example, a photoresist mixture containing a dispersion of poly(vinyl alcohol) nanoparticles can be spin-coated on a substrate, irradiated, and developed with isopropanol to remove non-crosslinked material, followed by the etchant water to remove poly(vinyl alcohol), thus leaving voids where the poly(vinyl alcohol) once resided.

An ion-conductor in accordance with examples described herein, e.g. comprising a crosslinked resist mixture and/or a polymerised resist mixture of examples described herein, is envisaged to have numerous uses. Hence in examples a device comprises the ion-conductor of examples described herein, such as an electrochemical, electromechanical, photoelectric, photonic, electrochromic, and/or electro-optic device. Such a device for example is, or comprises, a microchip assembly, a printed circuit board, a sensor, a battery, a photovoltaic cell, an electronic circuit, a microfluidic chip, an electronic component or another structure which relies on the flow of ions during its operation.

In some examples, such as those schematically illustrated by Figure 14, a microchip assembly 1320 (e.g. a microfabricated semiconductor structure or electronic circuit) comprises an ion-conductor, for example ion-conductor structure 1300, in accordance with examples described herein. The incorporation of the ion-conductor into a semiconductor microchip assembly in some examples is e.g. the use of the ion-conductor in devices such as batteries, sensors, photovoltaics, circuits and other uses which rely on the flow of ions during their operation.

The substrate comprises glass, quartz, sapphire, a ceramic, a metal, a polymer, carbon, or a photoresist, for example. In examples described herein, the substrate is for example part of a semiconductor microchip or wafer.

For examples of the crosslinked ion conductor described herein, direct current ion conductivity has been observed as up to 10⁻² Siemens per centimetre (S/cm, equivalent to x10⁻² kg⁻¹·m⁻³·s³·A²); however, higher values are envisaged. Typical values at 298 Kelvin are expected between 10⁻⁶ and 10⁻² S/cm. A person skilled in the art will appreciate that the conductivity values obtained will depend on several variables, including the chosen composition of the crosslinked material ion-conductor, any chosen additives, and the temperature of operation.

It is to be understood that any feature described in relation to any one example may be used alone, or in combination with other features described, and may also be used in combination with one or more features of any other of the example, or any combination of any other of the examples. Furthermore, equivalents and modifications not described above may also be employed without departing from the scope of the accompanying claims.

## Claims

1. A resist mixture for manufacturing an ion-conductor, the resist mixture comprising:
a polymer comprising siloxane; and
a salt comprising
a cationic component, and
an anionic component,
at least one of the cationic component or the anionic component bonded to the polymer by a linker covalently bonded to the at least one of the cationic component or the anionic component, and at least one of:
the resist mixture comprises a monomer and is polymerisable, or
the resist mixture comprises a crosslinker and is crosslinkable.

2. The mixture of claim 1, comprising a crosslinker covalently bonded to at least one of:
the monomer;
the polymer;
the cationic component; or
the anionic component.

3. The mixture of any previous claim, wherein the polymer is a first polymer, and the mixture further comprises a second polymer, the second polymer comprising a siloxane or a non-siloxane.

4. The mixture of claim 3, wherein the crosslinker or the monomer is covalently bonded to the second polymer.

5. The mixture of any previous claim, wherein at least one of:
the salt comprises at least one of a carbon-carbon bond or a carbon-hydrogen bond;
the mixture comprises a photoinitiator;
the mixture is a photoresist mixture;
the mixture is a negative photoresist mixture;
the cationic component comprises at least one of: a triazolium, a thioimidazolium, a quaternary ammonium, a protonated tertiary amine, imidazolium, a substituted imidazolium, a quaternary phosphonium, a protonated tertiary phosphine, chlorinium, pyrrolidinium, a substituted pyrrolidinium, pyridinium, a substituted pyridinium, a sulfonium or substituted sulfonium;
the anionic component comprises at least one of: a sulfonate, a phosphonate, alkoxide, a thiolate, an imidazolate, tetrakis(pentafluorophenyl)borate, bis(fluorosulfonyl)imide, a tosylate, (methyl)acrylate, a carboxylate, acetate, chloride, bromide, iodide, dimethylphosphate, methylsulfate, hexafluorophosphate, a triflate, bis(trifluoromethane)sulfonimide (bistriflimide/TFSI)), or tetrafluoroborate;
the mixture comprises a plasticiser;
the mixture comprises a redox active additive;
the mixture comprises a chromophore;
the mixture comprises a surfactant;
the cationic component comprises a multi-cationic component;
the anionic component comprises a multi-anionic component; or
the salt comprises a zwitterion.

6. The mixture of any previous claim, wherein the crosslinker or the monomer comprises: at least one of: a vinyl group, an acrylate group, an azide, an alkyne, an epoxy, a thiol, an olefin, an alcohol, an aldehyde, a carboxylate, an amine, a phosphine, a diene, diethylene glycol divinyl ether or diethylene glycol diacrylate; or an additive for modification of crosslink density.

7. A process of manufacturing an ion-conductor comprising:
at least partially depositing the mixture of any previous claim on a substrate; and at least one of
i) crosslinking a region of the mixture to form a region of crosslinked mixture and a region of mixture that has not been crosslinked, or
ii) polymerising a region of the mixture to form a region of polymerised mixture and a region of mixture that has not been polymerised.

8. The process of claim 7, comprising at least partially removing the region of the mixture that has not been crosslinked or the region of the mixture that has not been polymerised, wherein optionally at least one of:
removing comprises dissolving; or
at least partially removing the region of the mixture that has not been crosslinked or the region of the mixture that has not been polymerised produces a pattern of the ion-conductor on the substrate.

9. The process of claim 7 or claim 8 wherein at least one of:
the process comprises etching away a region of the mixture that has been at least one of crosslinked or polymerised;
the at least partially depositing the mixture comprises coating the mixture on the substrate;
the at least partially depositing the mixture comprises spin-coating;
the at least partially depositing the mixture comprises printing the mixture;
the process comprises exposing the mixture to radiation to cause at least one of the crosslinking or the polymerising;
the process comprises exposing the mixture to comprises at least one of an electron beam or electromagnetic radiation to cause at least one of the crosslinking or the polymerising;
the process comprises heating the mixture to cause at least one of the crosslinking or the polymerising;
a microchip or wafer comprises the substrate; or
the substrate comprises glass, quartz, sapphire, a ceramic, a metal, a polymer, carbon, or a photoresist.

10. An ion-conductor obtained by the process of any of claims 7 to 9.

11. An ion-conductor comprising:
a first polymer comprising siloxane; and
a salt comprising
a cationic component, and
an anionic component,
at least one of the cationic component or the anionic component bonded to the first polymer by a linker covalently bonded to the at least one of the cationic component or the anionic component, and at least one of:
the first polymer is crosslinked; or
the ion-conductor comprises a second polymer different from the first polymer, comprising a siloxane or non-siloxane, and optionally at least partially crosslinked.

12. The ion-conductor of claim 11, wherein at least one of:
the ion-conductor is solid-state;
the ion-conductor is quasi-solid state;
the salt comprises a carbon-carbon bond;
the salt comprises a carbon-hydrogen bond;
the cationic component comprises at least one of: a triazolium, a thioimidazolium, a quaternary ammonium, a protonated tertiary amine, imidazolium, a substituted imidazolium, a quaternary phosphonium, a protonated tertiary phosphine, chlorinium, pyrrolidinium, a substituted pyrrolidinium, pyridinium, a substituted pyridinium, sulfonium or a substituted sulfonium;
the anionic component comprises at least one of: a sulfonate, a phosphonate, alkoxide, a thiolate, an imidazolate, tetrakis(pentafluorophenyl)borate, bis(fluorosulfonyl)imide, a tosylate, (methyl)acrylate, a carboxylate, acetate, chloride, bromide, iodide, dimethylphosphate, methylsulfate, hexafluorophosphate, a triflate, bis(trifluoromethane)sulfonimide (bistriflimide/TFSI), or tetrafluoroborate;
the ion-conductor comprises an additive for modification of crosslink density;
the ion-conductor comprises a plasticiser;
the ion-conductor comprises a redox active additive;
the ion-conductor comprises a chromophore;
the ion-conductor comprises a surfactant;
the cationic component comprises a multi-cationic component;
the anionic component comprises a multi-anionic component; or
the salt is zwitterionic.

13. A device comprising the ion-conductor of claim 11 or claim 12.

14. The device of claim 13, wherein the device is at least one of an: electrochemical, electromechanical, photoelectric, photonic, electrochromic, or electro-optic device.

15. The device of claim 13 or claim 14, comprising at least one of: a microchip assembly, a printed circuit board, a sensor, a battery, a photovoltaic cell, an electronic circuit or a microfluidic chip.

## Patentansprüche

1. Resistmischung zum Herstellen eines Ionenleiters, die Resistmischung umfassend:
ein Polymer, umfassend Siloxan; und
ein Salz, umfassend
eine kationische Komponente und
eine anionische Komponente,
wobei mindestens eine der kationischen Komponente oder der anionischen Komponente an das Polymer durch einen Linker gebunden ist, der an die mindestens eine der kationischen Komponente oder der anionischen Komponente kovalent gebunden ist, und mindestens eines von:
der Resistmischung ein Monomer umfasst und polymerisierbar ist, oder
der Resistmischung einen Vernetzer umfasst und vernetzbar ist.

2. Mischung nach Anspruch 1, umfassend einen Vernetzer, der an mindestens eines von Folgendem kovalent gebunden ist:
das Monomer;
das Polymer;
die kationische Komponente; oder
die anionische Komponente.

3. Mischung nach einem der vorstehenden Ansprüche, wobei das Polymer ein erstes Polymer ist und die Mischung ferner ein zweites Polymer umfasst, das zweite Polymer umfassend ein Siloxan oder ein Nicht-Siloxan.

4. Mischung nach Anspruch 3, wobei der Vernetzer oder das Monomer an das zweite Polymer kovalent gebunden ist.

5. Mischung nach einem der vorstehenden Ansprüche, wobei mindestens eines von:
dem Salz mindestens eine von einer Kohlenstoff-Kohlenstoff-Bindung oder einer Kohlenstoff-Wasserstoff-Bindung umfasst;
der Mischung einen Fotoinitiator umfasst;
der Mischung eine Fotoresistmischung ist;
der Mischung eine negative Fotoresistmischung ist;
der kationischen Komponente mindestens eines umfasst von: einem Triazolium, ein Thioimidazolium, einem quaternären Ammonium, einem protonierten tertiären Amin, Imidazolium, einem substituierten Imidazolium, einem quaternären Phosphonium, einem protonierten tertiären Phosphin, Chlorinium, Pyrrolidinium, einem substituierten Pyrrolidinium, Pyridinium, einem substituierten Pyridinium, einem Sulfonium oder substituiertem Sulfonium;
der anionische Komponente mindestens eines umfasst von: einem Sulfonat, einem Phosphonat, einem Alkoxid, einem Thiolat, einem Imidazolat, Tetrakis(pentafluorophenyl)borat, Bis(fluorosulfonyl)imid, einem Tosylat, (Methyl)acrylat, einem Carboxylat, Acetat, Chlorid, Bromid, Iodid, Dimethylphosphat, Methylsulfat, Hexafluorophosphat, einem Triflat, Bis(trifluoromethan)sulfonimid (Bistriflimid/TFSI)) oder Tetrafluoroborat;
der Mischung einen Weichmacher umfasst;
der Mischung ein redoxaktives Additiv umfasst;
der Mischung einen Chromophor umfasst;
der Mischung ein Tensid umfasst;
der kationischen Komponente eine multikationische Komponente umfasst;
der anionischen Komponente eine multianionische Komponente umfasst; oder
dem Salz ein Zwitterion umfasst.

6. Mischung nach einem der vorstehenden Ansprüche, wobei der Vernetzer oder das Monomer umfasst: mindestens eines von: einer Vinylgruppe, einer Acrylatgruppe, einem Azid, einem Alkin, einem Epoxid, einem Thiol, einem Olefin, einem Alkohol, einem Aldehyd, einem Carboxylat, einem Amin, einem Phosphin, einem Dien, Diethylenglykoldivinylether oder Diethylenglykoldiacrylat; oder einem Additiv für die Modifikation der Vernetzungsdichte.

7. Verfahren zum Herstellen eines Ionenleiters, umfassend:
mindestens teilweises Aufbringen der Mischung nach einem der vorstehenden Ansprüche auf ein Substrat; und mindestens eines von
i) einem Vernetzen einer Region der Mischung, um eine Region der vernetzten Mischung und eine Region der Mischung auszubilden, die nicht vernetzt wurde, oder
ii) einem Polymerisieren einer Region der Mischung, um eine Region der polymerisierten Mischung und eine Region der Mischung auszubilden, die nicht polymerisiert wurde.

8. Verfahren nach Anspruch 7, umfassend ein mindestens teilweises Entfernen der Region der Mischung, die nicht vernetzt wurde, oder der Region der Mischung, die nicht polymerisiert wurde, wobei optional mindestens eines von:
dem Entfernen ein Auflösen umfasst; oder
dem mindestens teilweisen Entfernen der Region der Mischung, die nicht vernetzt wurde, oder der Region der Mischung, die nicht polymerisiert wurde, ein Muster des Ionenleiters auf dem Substrat erzeugt.

9. Verfahren nach Anspruch 7 oder 8, wobei mindestens eines von:
dem Verfahren ein Wegätzen einer Region der Mischung, die mindestens vernetzt oder polymerisiert wurde, umfasst;
dem mindestens teilweisen Aufbringen der Mischung das Beschichten des Substrats mit der Mischung umfasst;
dem mindestens teilweisen Aufbringen der Mischung ein Spin-Coating umfasst;
dem zumindest teilweisen Aufbringen der Mischung das Drucken der Mischung umfasst;
dem Verfahren ein Aussetzen der Mischung einer Strahlung umfasst, um mindestens eines der Vernetzung oder der Polymerisierung zu bewirken;
dem Verfahren das Aussetzen der Mischung mindestens eines von einem Elektronenstrahl oder einer elektromagnetischen Strahlung umfasst, um mindestens eines der Vernetzung oder der Polymerisierung zu bewirken;
dem Verfahren ein Erhitzen der Mischung umfasst, um mindestens eines der Vernetzung oder der Polymerisierung zu bewirken;
einem Mikrochip oder einem Wafer das Substrat umfasst; oder
dem Substrat Glas, Quarz, Saphir, Keramik, Metall, Polymer, Kohlenstoff oder Fotoresist umfasst.

10. Ionenleiter, der durch das Verfahren nach einem der Ansprüche 7 bis 9 erhalten wird.

11. Ionenleiter, umfassend:
ein erstes Polymer, umfassend Siloxan; und
ein Salz, umfassend
eine kationische Komponente und
eine anionische Komponente,
mindestens eine der kationischen Komponente oder der anionischen Komponente an das erste Polymer durch einen Linker gebunden ist, der an die mindestens eine der kationischen Komponente oder der anionischen Komponente kovalent gebunden ist, und mindestens eines von:
dem erste Polymer vernetzt ist; oder
dem Ionenleiter ein zweites Polymer umfasst, das sich von dem ersten Polymer unterscheidet, umfassend ein Siloxan oder Nicht-Siloxan und optional mindestens teilweise vernetzt ist.

12. lonenleiter nach Anspruch 11, wobei mindestens eines von:
dem Ionenleiter in festem Zustand ist;
dem Ionenleiter in quasi festem Zustand ist;
dem Salz eine Kohlenstoff-Kohlenstoff-Bindung umfasst;
dem Salz eine Kohlenstoff-Wasserstoff-Bindung umfasst;
der kationischen Komponente mindestens eines umfasst von: einem Triazolium, einem Thioimidazolium, einem quaternären Ammonium, einem protonierten tertiären Amin, Imidazolium, einem substituierten Imidazolium, einem quaternären Phosphonium, einem protonierten tertiären Phosphin, Chlorinium, Pyrrolidinium, einem substituierten Pyrrolidinium, Pyridinium, einem substituierten Pyridinium, Sulfonium oder einem substituierten Sulfonium;
der anionischen Komponente mindestens eines umfasst von: einem Sulfonat, einem Phosphonat, einem Alkoxid, einem Thiolat, einem Imidazolat, Tetrakis(pentafluorophenyl)borat, Bis(fluorosulfonyl)imid, einem Tosylat, (Methyl)acrylat, einem Carboxylat, Acetat, Chlorid, Bromid, Iodid, Dimethylphosphat, Methylsulfat, Hexafluorophosphat, einem Triflat, Bis(trifluoromethan)sulfonimid (Bistriflimid/TFSI) oder Tetrafluoroborat;
dem Ionenleiter ein Additiv für die Modifikation der Vernetzungsdichte umfasst;
dem lonenleiter einen Weichmacher umfasst;
dem lonenleiter ein redoxaktives Additiv umfasst;
dem lonenleiter einen Chromophor umfasst;
dem Ionenleiter ein Tensid umfasst;
der kationischen Komponente eine multikationische Komponente umfasst;
der anionischen Komponente eine multianionische Komponente umfasst; oder
dem Salz zwitterionisch ist.

13. Vorrichtung, umfassend den Ionenleiter nach Anspruch 11 oder 12.

14. Vorrichtung nach Anspruch 13, wobei die Vorrichtung mindestens eines ist von einer: elektrochemischen, elektromechanischen, fotoelektrischen, photonischen, elektrochromen oder elektrooptischen Vorrichtung.

15. Vorrichtung nach Anspruch 13 oder 14, umfassend mindestens eines von: einer Mikrochip-Baugruppe, einer Leiterplatte, einem Sensor, einer Batterie, einer Photovoltaikzelle, einer elektronischen Schaltung oder einem Mikrofluid-Chip.

## Revendications

1. Mélange de réserve pour la fabrication d'un conducteur ionique, le mélange de réserve comprenant :
un polymère comprenant du siloxane ; et
un sel comprenant
un composant cationique, et
un composant anionique,
au moins un du composant cationique ou du composant anionique lié au polymère par un liant lié de manière covalente à l'au moins un du composant cationique ou du composant anionique, et au moins un parmi :
le mélange de réserve comprend un monomère et est polymérisable, ou
le mélange de réserve comprend un réticulant et est réticulable.

2. Mélange selon la revendication 1, comprenant un réticulant lié de manière covalente à au moins un parmi :
le monomère ;
le polymère ;
le composant cationique ; ou
le composant anionique.

3. Mélange selon l'une quelconque revendication précédente, dans lequel le polymère est un premier polymère, et le mélange comprend en outre un second polymère, le second polymère comprenant un siloxane ou un non-siloxane.

4. Mélange selon la revendication 3, dans lequel le réticulant ou le monomère est lié de manière covalente au second polymère.

5. Mélange selon l'une quelconque revendication précédente, dans lequel au moins un parmi :
le sel comprend au moins une liaison carbone-carbone ou une liaison carbone-hydrogène ;
le mélange comprend un photo-initiateur ;
le mélange est un mélange de résine photosensible ;
le mélange est un mélange négatif de résine photosensible ;
le composant cationique comprend au moins un parmi : un triazolium, un thioimidazolium, un ammonium quaternaire, une amine tertiaire protonée, un imidazolium, un imidazolium substitué, un phosphonium quaternaire, une phosphine tertiaire protonée, un chlorinium, un pyrrolidinium, un pyrrolidinium substitué, un pyridinium, un pyridinium substitué, un sulfonium ou un sulfonium substitué ;
le composant anionique comprend au moins un parmi : un sulfonate, un phosphonate, un alcoxyde, un thiolate, un imidazolate, un borate de tétrakis(pentafluorophényle), un bis(fluorosulfonyl)imide, un tosylate, un acrylate (de méthyle), un carboxylate, acétate, chlorure, bromure, iodure, diméthylphosphate, méthylsulfate, hexafluorophosphate, un triflate, bis(trifluorométhane)sulfonimide (bistriflimide/TFSI)), ou tétrafluoroborate ;
le mélange comprend un plastifiant ;
le mélange comprend un additif redox actif ;
le mélange comprend un chromophore ;
le mélange comprend un agent tensioactif ;
le composant cationique comprend un composant multicationique ;
le composant anionique comprend un composant multi-anionique ; ou
le sel comprend un zwitterion.

6. Mélange selon l'une quelconque revendication précédente, dans lequel le réticulant ou le monomère comprend : au moins un parmi : un groupe vinyle, un groupe acrylate, un azide, un alcyne, un époxyde, un thiol, une oléfine, un alcool, un aldéhyde, un carboxylate, une amine, une phosphine, un diène, l'éther divinylique du diéthylène glycol ou le diacrylate de diéthylène glycol ; ou un additif permettant de modifier la densité de réticulation.

7. Procédé de fabrication d'un conducteur ionique comprenant :
le dépôt d'au moins partiellement le mélange selon l'une quelconque revendication précédente sur un substrat ; et au moins une parmi
i) la réticulation d'une région du mélange pour former une région de mélange réticulé et une région de mélange qui n'a pas été réticulée, ou
ii) la polymérisation d'une région du mélange pour former une région de mélange polymérisé et une région de mélange qui n'a pas été polymérisée.

8. Procédé selon la revendication 7, comprenant l'élimination au moins partielle de la région du mélange qui n'a pas été réticulée ou de la région du mélange qui n'a pas été polymérisée, dans lequel, éventuellement, au moins un parmi :
l'élimination comprend la dissolution ; ou
l'élimination au moins partielle de la partie du mélange qui n'a pas été réticulée ou de la partie du mélange qui n'a pas été polymérisée produit un motif du conducteur ionique sur le substrat.

9. Procédé selon la revendication 7 ou la revendication 8, dans lequel au moins un parmi :
le procédé comprend la corrosion d'une zone du mélange qui a été au moins une fois réticulée ou polymérisée ;
le dépôt au moins partiel du mélange comprend le revêtement du mélange sur le substrat ;
le dépôt au moins partiel du mélange comprend le revêtement par centrifugation ;
le dépôt au moins partiel du mélange comprend l'impression du mélange ;
le procédé comprend l'exposition du mélange à un rayonnement pour provoquer au moins l'une parmi la réticulation ou la polymérisation ;
le procédé comprend l'exposition du mélange à au moins l'un parmi un faisceau d'électrons ou un rayonnement électromagnétique pour provoquer au moins l'une parmi la réticulation ou la polymérisation ;
le procédé comprend le chauffage du mélange pour provoquer au moins l'une parmi la réticulation ou la polymérisation ;
une micropuce ou une plaquette comprend le substrat ; ou
le substrat comprend du verre, du quartz, du saphir, une céramique, un métal, un polymère, du carbone ou une résine photosensible.

10. Conducteur ionique obtenu par le procédé selon l'une quelconque des revendications 7 à 9.

11. Conducteur ionique comprenant :
un premier polymère comprenant du siloxane ; et
un sel comprenant
un composant cationique, et
un composant anionique,
au moins un parmi le composant cationique ou le composant anionique lié au premier polymère par un liant lié de manière covalente à l'au moins un du composant cationique ou du composant anionique, et au moins un parmi :
le premier polymère est réticulé ; ou
le conducteur ionique comprend un second polymère différent du premier polymère, comprenant un siloxane ou un non-siloxane, et éventuellement au moins partiellement réticulé.

12. Conducteur ionique selon la revendication 11, dans lequel au moins un parmi :
le conducteur ionique est à l'état solide ;
le conducteur ionique est à l'état quasi-solide ;
le sel comprend une liaison carbone-carbone ;
le sel comprend une liaison carbone-hydrogène ;
le composant cationique comprend au moins un parmi : un triazolium, un thioimidazolium, un ammonium quaternaire, une amine tertiaire protonée, un imidazolium, un imidazolium substitué, un phosphonium quaternaire, une phosphine tertiaire protonée, un chlorinium, un pyrrolidinium, un pyrrolidinium substitué, un pyridinium, un pyridinium substitué, un sulfonium ou un sulfonium substitué ;
le composant anionique comprend au moins un parmi : un sulfonate, un phosphonate, un alcoxyde, un thiolate, un imidazolate, un borate de tétrakis(pentafluorophényle), un bis(fluorosulfonyl)imide, un tosylate, un acrylate (de méthyle), un carboxylate, un acétate, chlorure, bromure, iodure, diméthylphosphate, sulfate de méthyle, hexafluorophosphate, un triflate, bis(trifluorométhane)sulfonimide (bistriflimide/TFSI) ou tétrafluoroborate ;
le conducteur ionique comprend un additif permettant de modifier la densité de réticulation ;
le conducteur ionique comprend un plastifiant ;
le conducteur ionique comprend un additif redox actif ;
le conducteur ionique comprend un chromophore ;
le conducteur ionique comprend un agent tensioactif ;
le composant cationique comprend un composant multicationique ;
le composant anionique comprend un composant multi-anionique ; ou
le sel est zwitterionique.

13. Dispositif comprenant le conducteur ionique selon la revendication 11 ou la revendication 12.

14. Dispositif selon la revendication 13, dans lequel le dispositif est au moins un parmi : un dispositif électrochimique, électromécanique, photoélectrique, photonique, électrochrome, ou électro-optique.

15. Dispositif selon la revendication 13 ou la revendication 14, comprenant au moins un parmi : un assemblage de micropuces, un circuit imprimé, un capteur, une batterie, une cellule photovoltaïque, un circuit électronique ou une puce microfluidique.
